# EUROPÄISCHE PATENTANMELDUNG

(11) **EP 3 930 434 A1**
(43) Veröffentlichungstag der Anmeldung: **29.12.2021**
(21) Anmeldenummer: 21181664.0
(22) Anmeldetag: 25.06.2021
(51) Int. Cl.: H05K 7/14

(54) **BAUGRUPPE MIT EINEM EINE TRAGSTRUKTUR AUSBILDENDEN KÜHLKÖRPERKERNELEMENT**

(30) Priorität: 25.06.2020 BE 202005466
(71) Anmelder: Phoenix Contact GmbH & Co. KG, 32825 Blomberg (DE)
(72) Erfinder: BEST, Frank, 31675 Bückeburg (DE); WELSLAU, Fabio, 32657 Lemgo (DE)

(57) **Zusammenfassung**

Eine Baugruppe eines elektrischen Geräts (1) umfasst zumindest eine elektrische Funktionsbaugruppe, die ein Trägerelement (13-16) und an dem Trägerelement (13-16) angeordnete elektrische oder elektronische Funktionskomponenten (18) aufweist, und eine Befestigungseinrichtung (12) zum Befestigen des elektrischen Geräts (1) an einer übergeordneten Baugruppe. Die Baugruppe umfasst zudem ein zumindest eine Flächenwandung (110, 113, 115) aufweisendes Kühlkörperkernelements (11) und ein mit dem Kühlkörperkernelement (11) verbindbares Außenelement (100, 11A-11D), wobei das Kühlkörperkernelement (11) eine Tragstruktur des elektrischen Geräts (1) ausbildet, an der die Befestigungseinrichtung (12) angeordnet ist, und das Außenelement (100, 11A-11D) derart mit dem Kühlkörperkernelement (11) verbindbar ist, dass die Funktionsbaugruppe zwischen der zumindest einen Flächenwandung (110, 113, 115) des Kühlkörperkernelements (11) und dem Außenelement (100, 11A-11D) aufgenommen ist.

## Beschreibung

Die Erfindung betrifft eine Baugruppe eines elektrischen Geräts nach dem Oberbegriff des Anspruchs 1, ein Baukastensystem und ein elektrisches Gerät.

Eine derartige Baugruppe umfasst zumindest eine elektrische Funktionsbaugruppe, die ein Trägerelement und an dem Trägerelement angeordnete elektrische oder elektronische Funktionskomponenten aufweist, und eine Befestigungseinrichtung zum Befestigen des elektrischen Geräts an einer übergeordneten Baugruppe, zum Beispiel einer Tragschiene.

Solche elektrischen Geräte dienen zum Beispiel dazu, an einer Tragschiene eine elektrische Funktionsanordnung zur Verfügung zu stellen, im Rahmen derer unterschiedliche elektrische Geräte miteinander kombiniert sein können, um unterschiedliche Funktionen, beispielsweise Automatisierungsfunktionen, an einer Industrieanlage, in der Gebäudetechnik oder in anderen Umgebungen, zur Verfügung zu stellen. Durch Anordnung an einer Tragschiene oder an anderen Befestigungseinrichtungen können elektrische Geräte beispielsweise in einem Schaltschrank miteinander kombiniert werden, wobei elektrische Geräte hierzu üblicherweise entlang einer Anreihrichtung aneinander angereiht und dazu rastend zum Beispiel mit einer Tragschiene oder einer anderen Tragbasis verbunden werden.

Im Betrieb kann an solchen elektrischen Geräten Wärme aufgrund einer elektrischen Verlustleistung entstehen. Wünschenswert ist daher, an solchen elektrischen Geräten eine Kühlung bereitzustellen, mittels derer elektrische und/oder elektronische Komponenten von elektrischen Funktionsbaugruppen, zum Beispiel an einer oder an mehreren Leiterplatten, gekühlt werden können. Hierzu werden üblicherweise Kühlkörper verwendet, die mit den elektrischen Funktionsbaugruppen verbunden werden, sodass über solche Kühlkörper Wärme aufgenommen, verteilt und gegebenenfalls, zum Beispiel über eine Konvektionsströmung, abgeführt werden kann.

Insbesondere elektrische Geräte zur Anwendung im Bereich der Kommunikationstechnologie, insbesondere 5G, im Bereich des Edge-Computings oder im Bereich der sogenannten Industrie 4.0 können im Betrieb erhebliche Wärme erzeugen, die abzuführen ist, um eine Überhitzung an solchen Geräten zu vermeiden.

Es besteht hierbei ein Bedarf für ein flexibel konfigurierbares elektrisches Gerät, das kompakt aufgebaut sein kann, dabei aber dennoch eine effiziente Kühlung an elektrischen oder elektronischen Komponenten, die an einer Leiterplatte angeordnet sind, zur Verfügung stellen kann.

Aus der DE 10 2014 109 984 A1 ist eine Elektronikgerätanordnung bekannt, die eine Mehrzahl von Basismodulen aufweist. Ein jedes Basismodul weist hierbei ein Isolierstoffgehäuse, einen Rastfuß zum Aufrasten auf eine Tragschiene und Steckkontakte zur elektrisch leitenden Verbindung zugeordneter Steckkontakte eines benachbarten Basismoduls auf. Auf ein Basismodul kann ein Elektronikmodul aufgesteckt werden, wobei das Elektronikmodul ein Zwischenelement aufweist, das zwischen Seitenwänden des Elektronikmoduls angeordnet werden kann. Kühlkörper können in dem Elektronikmodul aufgenommen werden.

Aus der DE 10 2015 111 277 A1 ist ein Kühlkörper für ein an einer Tragschiene anzubringendes, Verlustwärme erzeugendes Gerät bekannt.

Aufgabe der vorliegenden Erfindung ist es, eine Baugruppe eines elektrischen Geräts sowie ein Baukastensystem und ein elektrisches Gerät zur Verfügung zu stellen, die bei einfacher Bauform einen kompakten Aufbau, eine effiziente Montage und eine kostengünstige Fertigung ermöglichen und dabei eine effiziente Kühlung von Komponenten an einer Leiterplatte bereitstellen können.

Diese Aufgabe wird durch einen Gegenstand mit den Merkmalen des Anspruchs 1 gelöst.

Demnach umfasst die Baugruppe ein zumindest eine Flächenwandung aufweisendes Kühlkörperkernelement und ein mit dem Kühlkörperkernelement verbindbares Außenelement, wobei das Kühlkörperkernelement eine Tragstruktur des elektrischen Geräts ausbildet, an der die Befestigungseinrichtung angeordnet ist, und das Außenelement derart mit dem Kühlkörperkernelement verbindbar ist, dass die Funktionsbaugruppe zwischen der zumindest einen Flächenwandung des Kühlkörperkernelements und dem Außenelement aufgenommen ist.

Bei herkömmlichen elektrischen Geräten werden Kühlkörper üblicherweise mit einer elektrischen Funktionsbaugruppe, zum Beispiel einem Trägerelement in Form einer Leiterplatte einer elektrischen Funktionsbaugruppe verbunden, wobei die elektrische Funktionsbaugruppe in einem Gehäuse eingefasst ist und das Gehäuse eine tragende Struktur für das elektrische Gerät bereitstellt. Üblicherweise ist hierbei das Gehäuse zum Beispiel über eine an dem Gehäuse angeordnete Befestigungseinrichtung an einer Tragschiene festzulegen, sodass über das Gehäuse eine in dem Gehäuse eingefasste Baugruppe, insbesondere eine Leiterplatte mit einem daran befestigten Kühlkörper, an der Tragschiene gehalten werden kann.

In Abkehr von einem solchen herkömmlichen Konzept wird vorliegend vorgeschlagen, die tragende Struktur des elektrischen Geräts durch ein Kühlkörperkernelement auszubilden. Das Kühlkörperkernelement übernimmt somit nicht nur eine Funktion für eine Wärmeaufnahme und Wärmeableitung von einer elektrischen Funktionsbaugruppe, sondern stellt selbst ein tragendes Gerüst für das elektrische Gerät bereit. Auf ein zusätzliches Gehäuse kann in diesem Fall gegebenenfalls verzichtet werden. Jedenfalls ist nicht erforderlich, dass eine wesentliche tragende Funktion von einem Gehäuse übernommen wird, sondern die Tragstruktur des elektrischen Geräts wird durch das Kühlkörperkernelement bereitgestellt.

Das Kühlkörperkernelement weist eine oder mehrere Flächenwandungen auf, an denen eine oder mehrere elektrische Funktionsbaugruppen angeordnet werden können. Solche Flächenwandungen - auch bezeichnet als Basiswandung oder Basis des Kühlkörperkernelements - sind flächig erstreckt. An den Flächenwandungen sind die elektrischen Funktionsbaugruppen derart befestigbar, dass jede elektrische Funktionsbaugruppe strukturell an einer zugeordneten Flächenwandung gehalten ist und zudem Wärme, die an einer elektrischen Funktionsbaugruppe entsteht, über die Flächenwandungen aufgenommen und über das Kühlkörperkernelement abgeleitet werden kann.

Beispielsweise kann das Kühlkörperkernelement eine Mehrzahl von Flächenwandungen aufweisen, an denen je eine oder mehrere elektrische Funktionsbaugruppen befestigbar sind. Die Flächenwandungen können beispielsweise äußere Mantelflächen des Kühlkörperkernelements ausbilden, sodass elektrische Funktionsbaugruppen außenseitig des Kühlkörperkernelements an den Flächenwandungen angeordnet werden können, um auf diese Weise die elektrischen Funktionsbaugruppen an dem Kühlkörper festzulegen und dadurch das elektrische Gerät zu bereitzustellen.

Zumindest eine Funktionsbaugruppe ist hierbei - in montierter Stellung - zwischen einer zugeordneten Flächenwandung des Kühlkörperkernelements und einem an das Kühlkörperkernelement angesetzten, parallel zur Flächenwandung erstreckten Außenelement eingefasst, sodass die Funktionsbaugruppe, beispielsweise umfassend eine Leiterplatte mit daran angeordneten elektrischen oder elektronischen Funktionskomponenten, zwischen der Flächenwandung des Kühlkörperkernelements und dem Außenelement aufgenommen ist. Es wird somit eine Art Sandwichstruktur geschaffen, bei der das Kühlkörperkernelement eine innere Tragstruktur des elektrischen Geräts ausbildet und an einer flächig erstreckten Flächenwandung eine Funktionsbaugruppe trägt, wobei diese Funktionsbaugruppe wiederum außenseitig durch das flächig parallel zur Flächenwandung erstreckte Außenelement überdeckt ist und somit zwischen der Flächenwandung des Kühlkörperkernelements und dem Außenelement im Sandwich eingefasst ist.

An der (zumindest einen) Flächenwandung können, in einer Ausgestaltung, Profilelemente, auch bezeichnet als Offsets, zur Herstellung einer Wärmeleitverbindung mit der an der Flächenwandung angeordneten Funktionsbaugruppe angeordnet sein. Bei solchen Profilelementen kann es sich beispielsweise um an der Flächenwandung angeordnete Erhebungen handeln, die sich ausgehend von der Flächenwandung hin zu der Funktionsbaugruppe erstrecken und zur Aufnahme von Wärme an der Funktionsbaugruppe dienen. Solche Profilelemente können integral an der Flächenwandung geformt sein, zum Beispiel durch Fräsen. Solche Profilelemente können aber auch als zusätzliche Elemente an die Flächenwandung angeformt sein, zum Beispiel durch Kleben oder durch additive Fertigung an der Flächenwandung.

Bei dem Außenelement kann es sich beispielsweise um eine äußere Gehäusewandung handeln, die die Funktionsbaugruppe außenseitig flächig überdeckt. Bei dem Außenelement kann es sich aber auch, wie nachfolgend noch erläutert werden soll, um ein weiteres Kühlkörperteil handeln, sodass die Funktionsbaugruppe im Sandwich zwischen dem inneren Kühlkörperkernelement und dem äußeren Kühlkörperteil eingefasst ist und somit Wärme beidseitig der Funktionsbaugruppe aufgenommen und abgeführt werden kann.

Das Kühlkörperkernelement hierbei die Tragstruktur für das elektrische Gerät aus und trägt insbesondere die Befestigungseinrichtung, über die das elektrische Gerät an einer übergeordneten Baugruppe befestigt werden kann. Wie nachfolgend noch erläutert werden soll, kann die Befestigungseinrichtung beispielsweise zum Anordnen des elektrischen Geräts an einer Tragschiene ausgebildet sein, sodass über die Befestigungseinrichtung das elektrische Gerät beispielsweise in einem Schaltschrank montiert werden kann. Alternativ kann die Befestigungseinrichtung zum Beispiel als Montageplatte oder dergleichen zum Anbringen an einer übergeordneten Baugruppe, zum Beispiel an einer Wandung eines Schaltschranks oder dergleichen, ausgebildet sein, wobei über die Befestigungseinrichtung beispielsweise eine Schraubverbindung hergestellt werden kann.

Eine oder mehrere Funktionsbaugruppen können beispielsweise außenseitig einer oder mehrerer Flächenwandungen angeordnet werden. Möglich ist zusätzlich aber auch, eine elektrische Funktionsbaugruppe beispielsweise in einen Einschub innerhalb des Kühlkörperkernelements einzuschieben und die elektrische Funktionsbaugruppe somit innerhalb des Kühlkörperkernelements aufzunehmen, wobei die elektrische Funktionsbaugruppe wiederum vorzugsweise im Bereich einer Flächenwandung angeordnet wird, sodass Wärme an der Flächenwandung aufgenommen und abgeleitet werden kann.

In einer Ausgestaltung weist das Kühlkörperkernelement zwei Flächenwandungen auf, die einander gegenüberliegend angeordnet und parallel zueinander erstreckt sind, wobei elektrische Funktionsbaugruppen an einander abgewandten Seiten der zwei Flächenwandungen befestigbar sind. An einander gegenüberliegenden Flächenwandungen des Kühlkörperkernelements können somit jeweils eine oder mehrere elektrische Funktionsbaugruppen angeordnet werden, um auf diese Weise die elektrischen Funktionsbaugruppen mit dem Kühlkörper zu verbinden.

Zwischen den einander gegenüberliegenden Flächenwandungen sind beispielsweise Kühlrippen geformt. Zwischen den Flächenwandungen kann beispielsweise eine Konvektionsströmung strömen, sodass an den Kühlrippen zwischen den Flächenwandungen Wärme aufgenommen und mittels der Konvektionsströmung abgeleitet werden kann.

Außenelemente, beispielsweise in Form von Gehäusewandungen oder in Form von weiteren Kühlkörperteilen, können hierbei jeweils außenseitig der parallel zueinander erstreckten Flächenwandungen des Kühlkörperkernelements angeordnet sein, sodass Funktionsbaugruppen an den Flächenwandungen im Sandwich zwischen dem Kühlkörperkernelement und den jeweils außen angeordneten Außenelementen eingefasst sind.

In einer Ausgestaltung weist das Kühlkörperkernelement eine kubusförmige Gestalt auf, um eine kubusförmige Tragstruktur auszubilden. Hierzu kann das Kühlkörperkernelement beispielsweise vier Flächenwandungen aufweisen, die rechtwinklig zueinander angeordnet sind, sodass die Flächenwandungen einen Kubus bilden, an deren Außenseiten je eine oder mehrere elektrische Funktionsbaugruppen angeordnet werden können.

An jeder der Flächenwandungen kann hierbei eine Funktionsbaugruppe anordbar sein, wobei bei Herstellung des Gerätes nicht notwendigerweise an jeder Flächenwandung auch eine Funktionsbaugruppe angeordnet ist, aber an den Flächenwandungen zumindest eine Aufnahme ausgebildet ist, die zur Aufnahme einer Funktionsbaugruppe dienen kann. Zumindest an einer der Flächenwandungen ist hierbei - in montierter Stellung - ein Außenelement angeordnet, sodass an der jeweiligen Flächenwandung eine Funktionsbaugruppe im Sandwich zwischen der Flächenwandung und dem Außenelement aufgenommen werden kann. Ein solches Außenelement ist aber nicht zwingend an sämtlichen Flächenwandungen vorzusehen.

In einer Ausgestaltung ist die zumindest eine elektrische Funktionsbaugruppe an einer ersten Seite einer zugeordneten Flächenwandung befestigbar. Kühlrippen sind an einer der ersten Seite abgewandten, zweiten Seite der Flächenwandung geformt. Die elektrische Funktionsbaugruppe kann sich mit ihrem Trägerelement, das beispielsweise durch eine Leiterplatte ausgebildet ist, parallel zur Flächenwandung erstrecken und unmittelbar anliegend an der Flächenwandung oder mit Abstand zu der Flächenwandung angeordnet sein. Über die Flächenwandung kann Wärme an der elektrischen Funktionsbaugruppe aufgenommen und in Richtung der Kühlrippen geleitet werden, wobei beispielsweise eine Konvektionsströmung an den Kühlrippen entlang strömen kann, um Wärme an den Kühlrippen aufzunehmen und von dem Kühlkörper abzuleiten.

In einer Ausgestaltung weist das Kühlkörperkernelement zumindest einen Strömungsschacht auf, der so geformt ist, dass eine Konvektionsströmung durch das Kühlkörperkernelement hindurchströmen kann. Bei bestimmungsgemäßer Anordnung des Kühlkörperkernelements, beispielsweise bei Befestigung eines zugeordneten elektrischen Geräts an einer Tragschiene, kann sich der Strömungsschacht beispielsweise entlang einer vertikalen, der Schwerkraftrichtung entsprechenden Richtung erstrecken, sodass eine Konvektionsströmung vertikal durch das Kühlkörperkernelement hindurchströmen kann. Weist das Kühlkörperkernelement beispielsweise eine Kubusform auf, so ist der Strömungsschacht zentral innerhalb des Kühlkörperkernelements gebildet, sodass das Kühlkörperkernelement in seinem Inneren von einer Konvektionsströmung durchströmt werden kann, um Wärme im Inneren des Kühlkörperkernelements aufzunehmen und abzuleiten. Elektrische Funktionsbaugruppen können hierbei an Flächenwandungen außenseitig des Kühlkörperkernelements oder in Einschüben innerhalb des Kühlkörperkernelements angeordnet sein, wobei Wärme an den elektrischen Funktionsbaugruppen aufgenommen und nach innen in Richtung des Strömungsschachtes geleitet werden kann, um Wärme innerhalb des Strömungsschachts durch eine Konvektionsströmung abzuleiten.

Kühlrippen können beispielsweise in den Strömungsschacht hineinragen, sodass Wärme effizient innerhalb des Strömungsschachts durch eine Konvektionsstörung aufgenommen werden kann.

Der Strömungsschacht kann vertikal entlang der Schwerkraftrichtung - bei bestimmungsgemäßer Ausrichtung und Verwendung des elektrischen Geräts - gerichtet sein, wobei dies jedoch nicht zwingend ist. Der Strömungsschacht kann beispielsweise auch horizontal und somit quer zur Schwerkraftrichtung gerichtet sein.

Zur Erzeugung eines Fluidstroms durch den Strömungsschacht kann beispielsweise auch ein aktiver, zum Beispiel elektrisch betriebener Lüfter vorgesehen sein, um einen Fluidstrom, insbesondere einen Luftstrom, durch den Strömungsschacht zu befördern.

Zusätzlich oder alternativ zu einem Strömungsschacht kann an dem Kühlkörper eine aktive Kühlung bereitgestellt werden, beispielsweise indem an dem Kühlkörper eine Kühlmittelleitung zum Durchströmen mit einem Kühlmittel, zum Beispiel einem flüssigen oder gasförmigen Fluid, geformt wird.

Kühlrippen an der zumindest einen Flächenwandung können beispielsweise parallel zueinander erstreckt und von der Flächenwandung zum Beispiel in Richtung des Strömungsschachts vorstehen. Kühlrippen können jedoch auch quer oder schräg zu einer Flächenwandung verlaufen, wobei mehrere Kühlrippen gemeinsam beispielsweise eine Wabenform oder eine Sternform oder eine andere Geometrie zum Beispiel innerhalb des Strömungsschachts ausbilden können.

Während Kühlrippen in den Strömungsschacht hineinragen und somit innenseitig einer zugeordneten Flächenwandung geformt sind, können elektrische Funktionsbaugruppen beispielsweise außenseitig des Kühlkörperkernelements an äußeren Flächenwandungen des Kühlkörperkernelements befestigt werden, sodass Wärme über das Kühlkörperkernelement von den elektrischen Funktionsbaugruppe nach innen in Richtung der Kühlrippen und des Strömungsschachts geleitet werden kann.

In einer Ausgestaltung weist die Baugruppe ein aus einem elektrisch isolierenden Material gefertigtes Stirnwandungselement auf, das mit dem Kühlkörperkernelement verbunden werden kann und zur stirnseitigen Abdeckung des Kühlkörperkernelements dient. Insbesondere kann das Stirnwandungselement zumindest eine Strömungsöffnung für einen Fluidstrom aufweisen und dazu ausgestaltet sein, das Kühlkörperkernelement im Bereich des Strömungsschachts zumindest teilweise zu überdecken. Mittels des Stirnwandungselements kann somit eine Abdeckung des Kühlkörperkernelements im Bereich des Strömungsschachts bereitgestellt werden, sodass das Kühlkörperkernelement nach außen nicht freiliegt, sondern durch das Stirnwandungselement überdeckt ist.

Durch das Stirnwandungselement kann hierbei auch eine elektrische und/oder thermische Isolation bereitgestellt werden, sodass ein Nutzer, der das elektrische Gerät anfasst, nicht unmittelbar mit dem Kühlkörperkernelement in Berührung kommt und vor elektrischer und/oder thermischer Einwirkung geschützt ist. Das Stirnwandungselement kann somit eine elektrische und/oder thermische Isolation und zudem eine optische Blende für das Kühlkörperkernelement bereitstellen.

In einer Ausgestaltung ist das Außenelement durch ein zu dem Kühlkörper zusätzliches Kühlkörperteil gebildet, das mit dem Kühlkörper verbindbar ist, um eine elektrische Funktionsbaugruppe zwischen dem Kühlkörperteil und dem Kühlkörper aufzunehmen. Während das Kühlkörperkernelement beispielsweise eine kubusförmige Gestalt aufweisen kann, die einen Kern des elektrischen Geräts ausbildet, kann das zusätzliche Kühlkörperteil beispielsweise außenseitig einer Flächenwandung des Kühlkörperkernelements angeordnet werden, sodass eine an der Flächenwandung befestigte elektrische Funktionsbaugruppe außenseitig durch das Kühlkörperteil zumindest teilweise überdeckt ist. Über das Kühlkörperteil kann Wärme auch außenseitig der elektrischen Funktionsbaugruppe aufgenommen und abgeleitet werden, wobei das Kühlkörperteil mechanisch und auch thermisch an das Kühlkörperkernelement gekoppelt sein kann, sodass Wärme über das Kühlkörperteil sowohl nach außen abgegeben als auch hin zum Kühlkörper geleitet werden kann, um Wärme von der elektrischen Funktionsbaugruppe abzuführen. Dadurch, dass das Kühlkörperteil beispielsweise außenseitig und das Kühlkörperkernelement innenseitig einer zugeordneten elektrischen Funktionsbaugruppe angeordnet ist, kann Wärme effizient an der elektrischen Funktionsbaugruppe aufgenommen und von der elektrischen Funktionsbaugruppe abgeleitet werden

Beispielsweise kann an einigen oder an allen Flächenwandungen des Kühlkörperkernelements je ein zusätzliches Kühlkörperteil angeordnet werden, sodass an den Flächenwandungen des Kühlkörperkernelements eine oder mehrere elektrische Funktionsbaugruppen außenseitig durch ein Kühlkörperteil zumindest abschnittsweise abgedeckt und eingefasst sein können.

In anderer Ausgestaltung kann das Außenelement aber auch durch eine Gehäusewandung eines das Kühlkörperkernelement einhausenden Gehäuses gebildet sein. Die Gehäusewandung ist mit dem Kühlkörperkernelement verbindbar, um die zumindest eine elektrische Funktionsbaugruppe zwischen der zumindest einen Flächenwandung und der Gehäusewandung aufzunehmen. Die Gehäusewandung überdeckt das Kühlkörperkernelement somit im Bereich der die Funktionsbaugruppe tragenden Flächenwandung außenseitig und kann beispielsweise aus einem elektrisch und/oder thermisch isolierenden Material gefertigt sein. Zudem stellt die Gehäusewandung einen optischen Abschluss für das Kühlkörperkernelement nach außen hin zur Verfügung, sodass die Funktionsbaugruppe an dem Kühlkörperkernelement von außen nicht sichtbar ist.

In einer Ausgestaltung ist das Außenelement schwimmend mit dem Kühlkörperkernelement verbunden derart, dass das Außenelement zumindest entlang einer Raumrichtung zu dem Kühlkörperkernelement bewegbar ist. Das Außenelement kann beispielsweise senkrecht zur Flächenwandung des Kühlkörperkernelements bewegbar sein, sodass die Verbindung des Außenelements mit der Flächenwandung des Kühlkörperkernelements entlang einer Normalenrichtung relativ zur Flächenwandung mit Spiel ausgebildet ist. Alternativ kann das Außenelement auch tangential, also in der Ebene der Flächenwandung, relativ zu der Flächenwandungen beweglich sein, also mit Spiel mit der Flächenwandung verbunden sein. Durch eine solche schwimmende Befestigung können Toleranzen und Lageänderungen zum Beispiel aufgrund einer thermischen Ausdehnung ausgeglichen werden.

Die Baugruppe weist eine Befestigungseinrichtung zum Befestigen des elektrischen Geräts an einer übergeordneten Baugruppe, zum Beispiel einer Tragschiene, auf, wobei die Befestigungseinrichtung an dem Kühlkörperkernelement integral geformt sein kann oder als modulares Element an dem Kühlkörperkernelement befestigbar ist.

Anstelle einer Befestigungseinrichtung zum Befestigen des elektrischen Geräts an einer Tragschiene kann das Kühlkörperkernelement aber auch mit einer anderen Befestigungseinrichtung zum Befestigen des elektrischen Geräts an einer anderen Befestigungsbaugruppe, zum Beispiel einer Montagefläche eines Schaltschranks oder dergleichen, verbunden werden, sodass das elektrische Gerät durch Auswahl einer geeigneten Befestigungseinrichtung modular konfiguriert werden kann, um das elektrische Gerät an einer Befestigungswandung zum Beispiel eines Schaltschranks, an einer Montagefläche oder an einer anderen zugeordneten Tragbasis festzulegen.

Die Befestigungseinrichtung zur Befestigung an der übergeordneten Baugruppe kann generell zur Befestigung an einer Tragschiene, an einem Mast, einer Stange oder auch an einer Wandung ausgebildet sein. Über die Befestigungseinrichtung wird das elektrische Gerät an der übergeordneten Baugruppe befestigt und getragen. Unterschiedliche Befestigungseinrichtungen können hierbei zur Befestigung an unterschiedlichen Tragschienen (nach unterschiedlichen Industriestandards) ausgestaltet sein. Eine Befestigungseinrichtung zur Befestigung an einer Stange oder einem Mast kann zum Beispiel nach Art einer Schelle ausgestaltet sein. Eine Befestigungseinrichtung zur Befestigung an einer Wandung kann beispielsweise als anschraubbare Halteplatte oder einen Winkel ausgebildet sein. Zudem kann die Befestigungseinrichtung zur Anbindung an eine Tragbaugruppe, zum Beispiel einen Ständer, ausgestaltet sein und dazu zum Beispiel eine VESA-Befestigung ermöglichen.

Die Befestigungseinrichtung kann gegebenenfalls in unterschiedlichen Ausrichtungen an dem Kühlkörperkernelement anbringbar sein, sodass über die Befestigungseinrichtung das elektrische Gerät in unterschiedlichen Orientierungen mit der übergeordneten Baugruppe verbindbar ist.

In einer Ausgestaltung ist das Trägerelement der zumindest einen elektrischen Funktionsbaugruppe durch eine Leiterplatte gebildet. Elektrische und elektronische Funktionskomponenten in Form von elektrischen Bauteilen oder elektronischen Komponenten können an einer solchen Leiterplatte angeordnet sein und gemeinsam mit der Leiterplatte die elektrische Funktionsbaugruppe ausbilden. Über die Leiterplatte kann eine jeweilige elektrische Funktionsbaugruppe an einer zugeordneten Flächenwandung des Kühlkörperkernelements angeordnet werden, wobei das Kühlkörperkernelement eine tragende Struktur des elektrischen Geräts ausbildet und im Betrieb Wärme von der elektrischen Funktionsbaugruppe in das Kühlkörperkernelement eingeleitet und über das Kühlkörperkernelement abgeleitet werden kann.

Die elektrische Funktionsbaugruppe kann durch eine Leiterplatte mit daran angeordneten elektrischen oder elektronischen Komponenten gebildet sein. Die Funktionsbaugruppe kann hierbei beispielsweise auch mehrerer Leiterplatten aufweisen, die funktional miteinander verbunden sind. Beispielsweise kann die Funktionsbaugruppe eine Hauptleiterplatte, auch bezeichnet als Mainboard, aufweisen, mit der eine weitere Leiterplatte, zum Beispiel in Form eines sogenannten SOM-Boards, verbunden werden kann. Ein solches SOM-Board (SOM: System on Module) kann eine modulare elektronische Funktionskomponente bereitstellen, die zum Beispiel steckend mit der Hauptleiterplatte verbunden und ausgetauscht werden kann, um das elektrische Gerät zu konfigurieren.

In einer Ausgestaltung sind an der zumindest einen Flächenwandung eine Mehrzahl von Auflageabschnitten geformt, an denen das Trägerelement der zumindest einen elektrischen Funktionsbaugruppe befestigbar ist. Die Auflageabschnitte können zum Beispiel durch integral an der Flächenwandung geformte Zapfen oder Rippen gebildet sein, die die Funktionsbaugruppe in bestimmungsgemäßer Position zu der Flächenwandung halten. Durch das Vorsehen solcher Auflageabschnitte kann eine toleranzunempfindliche Anordnung der Funktionsbaugruppe an der Flächenwandung ermöglicht werden, insbesondere mit Blick auf Toleranzen in der Befestigung der elektrischen oder elektronischen Funktionskomponenten an dem Trägerelement.

Über die Auflageabschnitte kann insbesondere eine definierte Lage des Trägerelements der Funktionsbaugruppe, beispielsweise der Leiterplatte, zu der Flächenwandung eingestellt werden. Über die Auflageabschnitte wird das Trägerelement in befestigter Stellung mit Abstand zu der zumindest einen Flächenwandung angeordnet, sodass das Trägerelement in definierter Lage zu der Flächenwandung gehalten wird.

Beispielsweise sind an der zumindest einen Flächenwandung Auflageabschnitte in Form von Rippenabschnitten geformt, die Stützkanten ausbilden, an denen das Trägerelement der zumindest einen elektrischen Funktionsbaugruppe befestigbar ist. Über solche Rippenabschnitte, die von der Flächenwandung zum Beispiel nach außen vorstehen, kann die elektrische Funktionsbaugruppe, insbesondere das Trägerelement der elektrischen Funktionsbaugruppe, mit einem vorbestimmten Abstand zu der Flächenwandung montiert werden, sodass das Trägerelement der elektrischen Funktionsbaugruppe mit Abstand zu der Flächenwandung zu liegen kommt. Die elektrische Funktionsbaugruppe nimmt somit eine definierte Lage zu der Flächenwandung ein und ist über die an den Rippenabschnitten geformten Stützkanten zu der Flächenwandung abgestützt.

Alternativ zu solchen an einer Flächenwandung geformten Rippenabschnitten können auch Distanzhülsen oder andere Distanzelemente vorgesehen sein, die das Trägerelement einer elektrischen Funktionsbaugruppe auf Abstand zu einer zugeordneten Flächenwandung halten.

In einer Ausgestaltung ist das Kühlkörperkernelement integral und einstückig aus einem wärmeleitfähigen Material gefertigt, beispielsweise einem Metallmaterial, insbesondere einem Kupfer-, Aluminium- oder Zinkmaterial. Das Kühlkörperkernelement kann beispielsweise aus einem Stranggusssprofil, zum Beispiel einem Aluminiumsstranggussprofil, geformt sein. Alternativ kann das Kühlkörperkernelement auch aus einem Stück gefräst sein. Das Kühlkörperkernelement kann beispielsweise dem elektrischen Gerät angepasst sein, indem beispielsweise Freimachungen zur Aufnahme von zum Beispiel an einer Leiterplatte angeordneten Komponenten durch Fräsen in das Kühlkörperkernelement eingebracht sind.

Alternativ kann das Kühlkörperkernelement auch (im Ausgangszustand) mehrstückig aus einem wärmeleitfähigen Materialverbund geformt sein. Der Kühlkörper kann beispielsweise durch plattenförmige Elemente hergestellt sein, die in wärmeleitfähiger Weise miteinander verbunden sind, um einen wärmeleitfähigen Verbund aus einzelnen Platten zu schaffen.

Nach einem weiteren Aspekt wird ein Baukastensystem einer Baugruppe der vorangehend beschriebenen Art zur Verfügung gestellt. Das Baukastensystem umfasst eine Gruppe von unterschiedlichen Kühlkörperkernelementen und eine Gruppe von unterschiedlichen, jeweils mit dem Kühlkörperkernelement verbindbaren Außenelementen. Zur Herstellung des elektrischen Geräts kann ein Anwender eines der Kühlkörperkernelemente und eines oder mehrere der Außenelemente auswählen, um auf diese Weise das elektrische Gerät zu konfigurieren und durch Montieren der Außenelemente mit dem Kühlkörperkernelement herzustellen.

Es wird somit ein Baukastensystem geschaffen, bei dem das elektrische Gerät durch Auswahl von Komponenten in flexibler Weise konfigurierbar ist. Beispielsweise können Kühlkörperkernelemente unterschiedlicher Breiten, gemessen zum Beispiel entlang der Längserstreckungsrichtung einer Tragschiene, aufweisen, sodass elektrische Geräte unterschiedlicher Breiten geschaffen werden können. Abhängig zum Beispiel von einer Leistungsklasse kann somit die Dimension des Kühlkörperkernelements variiert werden, wobei unabhängig von zum Beispiel der Breite des Kühlkörperkernelements gleiche Außenelemente mit dem Kühlkörperkernelement verbunden werden können und somit ein Baukasten zum Herstellen des elektrischen Geräts geschaffen wird.

Bei dem Baukastensystem können die Außenelemente zum Beispiel Kühlkörperteile und Gehäusewandungen darstellen. Das elektrische Gerät kann somit wahlweise derart konfiguriert werden, dass an ein Kühlkörperkernelement Außenelemente in Form von weiteren Kühlkörperteilen oder in Form von Seitenwandungen angesetzt werden können.

Bestandteil des Baukastensystems kann zum Beispiel weiterhin ein Stirnwandungselement sein, wobei das elektrische Gerät wahlweise mit oder ohne Stirnwandungselement hergestellt werden kann.

Bestandteil des Baukastensystems können zudem eine oder mehrere modulare Befestigungseinrichtungen sein, die mit den unterschiedlichen Kühlkörperkernelementen kombinierbar sind. Die Befestigungseinrichtungen können zum Beispiel zur Befestigung an einer Tragschiene, an einem Mast, einer Stange oder an einer Wandung ausgebildet sein.

Eine Befestigungseinrichtung kann gegebenenfalls auch integral an dem Kühlkörperkernelement geformt sein, wobei unterschiedliche Kühlkörperkernelemente unterschiedliche Befestigungseinrichtungen aufweisen können.

Nach einem weiteren Aspekt sind bei einem elektrischen Gerät ein oder mehrere elektrische Funktionsbaugruppen mit einer oder mehreren Flächenwandungen des Kühlkörperkernelements verbunden. Elektrische oder elektronische Funktionskomponenten einer elektrischen Funktionsbaugruppe können hierbei an einer einer zugeordneten Flächenwandung zugewandten Seite des Trägerelements der elektrischen Funktionsbaugruppe und/oder an einer von der zugeordneten Flächenwandung abgewandten Seite des Trägerelements angeordnet sein. Elektrische oder elektronische Funktionskomponenten können an einer Seite des Trägerelements, zum Beispiel ausgebildet durch eine Leiterplatte, oder an beiden Seiten angeordnet sein. Die elektrischen oder elektronischen Funktionskomponenten können hierbei der jeweils zugeordneten Flächenwandung des Kühlkörperkernelements zugewandt oder von der Flächenwandung abgewandt sein.

Bei der Herstellung des elektrischen Geräts kann eine thermische Kontaktkraft, insbesondere zwischen dem Kühlkörperkernelement, dem Außenelement und der dazwischen angeordneten Funktionsbaugruppe automatisch eingestellt werden, zum Beispiel durch das Fügen bei Herstellung einer Schraub- oder Klebeverbindung oder gegebenenfalls über eine Federkraft in der Abstützung der Teile zueinander..

Bei montierter elektrischer Funktionsbaugruppe ist das Trägerelement zum Beispiel im Wesentlichen parallel zu einer zugeordneten Flächenwandung erstreckt, sodass sich das Trägerelement der elektrischen Funktionsbaugruppe flächig entlang der zugeordneten Flächenwandung erstreckt.

Sind elektrische und/oder elektronische Funktionskomponenten beidseitig des Trägerelements, beispielsweise in Form der Leiterplatte, angeordnet, so kann über das innere Kühlkörperkernelement und das außenseitig mit dem Kühlkörperkernelement verbundene, die Flächenwandung zumindest abschnittsweise überdeckende Außenelement zum Beispiel in Form eines weiteren Kühlkörperteils Wärme an Funktionskomponenten beidseits des Trägerelements aufgenommen und abgeleitet werden. Dies ermöglicht eine Kühlung durch Wärmeaufnahme und Wärmeabfuhr an beiden Seiten des Trägerelements. Dadurch, dass die Funktionsbaugruppe im Sandwich zwischen dem Kühlkörperkernelement und dem zugeordneten Außenelement, insbesondere in Form eines weiteren Kühlkörperteils, aufgenommen ist, ist somit eine effiziente Kühlung der Komponenten auch bei großer Wärmeentwicklung möglich.

Das Kühlkörperkernelement ist, in einer Ausgestaltung, über eine oder mehrere Wärmeleitverbindungen mit einer oder mehreren Funktionskomponenten an einer oder mehreren Trägerelementen thermisch verbunden. Die Wärmeleitverbindungen stellen eine thermische Kopplung einer wärmeproduzierenden Komponente, zum Beispiel eines elektronischen Prozessors oder dergleichen, mit dem Kühlkörperkernelement her.

Die Wärmeleitverbindungen können beispielsweise integral mit dem Kühlkörperkernelement geformt sein und zum Beispiel zapfenförmig von einer Tragwandung des Kühlkörperkernelements vorstehen, um thermisch an die jeweils zugeordnete Komponente anzukoppeln. Eine solche Wärmeleitverbindung kann sich beispielsweise durch eine Öffnung in dem Trägerelement, zum Beispiel in Form einer Leiterplatte, hindurcherstrecken, um eine thermische Kopplung mit einer Komponente an einer dem Kühlkörperkernelement abgewandten Seite der Leiterplatte herzustellen.

Die Wärmeleitverbindung kann beispielsweise über eine Wärmeleitschicht, zum Beispiel in Form einer Wärmeleitpaste, an eine Funktionskomponente einer elektrischen Funktionsbaugruppe ankoppeln, wobei die Funktionskomponente zum Beispiel an einer der Flächenwandung abgewandten Seite des Trägerelements der elektrischen Funktionsbaugruppe angeordnet ist und über die Wärmeleitverbindung durch das Trägerelement hindurch mit der Flächenwandung thermisch gekoppelt ist, elektrisch aber an die der Flächenwandung abgewandte Seite des Trägerelements angeschlossen ist, beispielsweise indem elektrische Verbindungen zwischen der Funktionskomponente und Leiterbahnen des Trägerelements an der der Flächenwandung abgewandten Seite des Trägerelements geschaffen sind.
Eine solche Wärmeleitverbindung kann auch über ein zusätzliches, zum Beispiel über eine Fügetechnik (zum Beispiel durch Kleben) mit dem Kühlkörperkernelement verbundenes Element geschaffen sein, wobei die Wärmeleitverbindung wiederum eine thermische Kopplung zwischen einer Komponente an einer Leiterplatte und dem Kühlkörperkernelement herstellt.

Über eine solche Wärmeleitverbindung kann insbesondere eine Funktionskomponente in Form eines SOM-Boards thermisch angebunden werden. Das SOM-Board kann beispielsweise an einer dem Kühlkörperkernelement abgewandten Außenseite des Trägerelements angeordnet sein, wobei über die Wärmeleitverbindung eine rückseitige thermische Anbindung an das Kühlkörperkernelement erfolgt.

Bei dem elektrischen Gerät wird die tragende Struktur durch das Kühlkörperkernelement selbst bereitgestellt. An dem Kühlkörperkernelement kann zusätzlich ein das Kühlkörperkernelement nach außen hin umgebendes, zum Beispiel elektrisch isolierendes Gehäuse angeordnet sein, wobei das Gehäuse über das Kühlkörperkernelement getragen und über das Kühlkörperkernelement zum Beispiel an einer zugeordneten Tragschiene oder einer anderen Tragbasis befestigbar ist. Das Gehäuse übernimmt somit vorteilhafterweise selbst keine tragende Funktion.

Das elektrische Gerät kann Anschlüsse zum Anschließen von elektrischen Leitungen aufweisen. Hierzu können an einer oder an mehreren Leiterplatten Steckverbindermodule angebracht sein, an die zugeordnete Gegensteckverbinder angeschlossen werden können.

Anschlüsse können zusätzlich oder alternativ an einem Oberteil, zum Beispiel einem Kunststoffformteil, angebracht sein, das an dem Kühlkörperkernelement befestigt ist. Eine Leiterplatte des elektrischen Geräts kann beispielsweise eingebettete Komponenten aufweisen (sogenanntes "embedded PCB"). Beispielsweise kann die Leiterplatte durch ein sogenanntes SOM-Board (SOM steht für "System on module") ausgebildet sein oder mit einem solchen SOM-Board verbindbar sein.

Das elektrische Gerät kann unterschiedliche Leistungsklassen aufweisen und kann insofern skalierbar sein. Das elektrische Gerät kann zudem unterschiedliche Formfaktoren aufweisen.

Ein elektrisches Gerät der beschriebenen Art kann insbesondere zur Anwendung im Bereich der Kommunikationstechnologie, insbesondere 5G, im Bereich des Edge-Computings oder im Bereich der sogenannten Industrie 4.0 ausgebildet sein.

Der der Erfindung zugrunde liegende Gedanke soll nachfolgend anhand der in den Figuren dargestellten Ausführungsbeispiele näher erläutert werden. Es zeigen:
- Fig. 1: eine Ansicht eines Ausführungsbeispiels eines elektrischen Geräts mit einem eine Tragstruktur ausbildenden Kühlkörper;
- Fig. 2: eine andere Ansicht des elektrischen Geräts;
- Fig. 3: eine Explosionsansicht des elektrischen Geräts;
- Fig. 4: eine Ansicht des elektrischen Geräts von unten;
- Fig. 5: eine schematische Ansicht eines Ausführungsbeispiels eines elektrischen Geräts mit einer durch ein Kühlkörperkernelement gebildeten Tragstruktur;
- Fig. 6: eine schematische Ansicht einer Verbindung einer Komponente einer Leiterplatte mit einem Kühlkörper;
- Fig. 7: eine Ansicht eines weiteren Ausführungsbeispiels eines elektrischen Geräts mit einem eine Tragstruktur ausbildenden Kühlkörper;
- Fig. 8: eine andere Ansicht des elektrischen Geräts;
- Fig. 9: eine Explosionsansicht des elektrischen Geräts;
- Fig. 10: eine Ansicht des elektrischen Geräts von unten;
- Fig. 11: eine schematische Ansicht eines anderen Ausführungsbeispiels eines elektrischen Geräts mit einer durch ein Kühlkörperkernelement gebildeten Tragstruktur; und
- Fig. 12: die Ansicht gemäß Fig. 1, mit einem Stirnwandungselement zum stirnseitigen Abdecken des Kühlkörperkernelements.

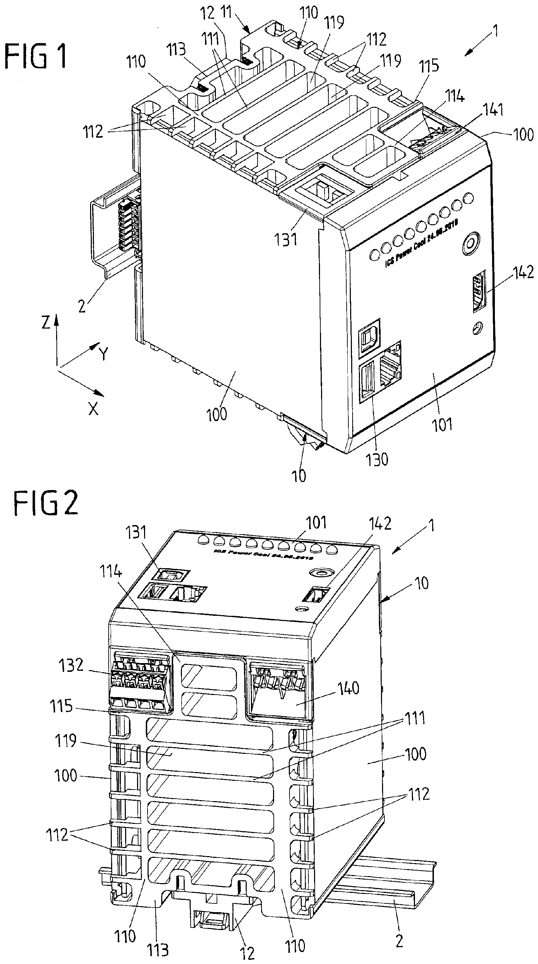

Fig. 1 bis 4 zeigen ein Ausführungsbeispiel eines elektrischen Geräts 1, das zusammen mit anderen elektrischen Geräten an einer Tragschiene 2 angeordnet werden kann, um beispielsweise in einem Schaltschrank durch variable Kombination von unterschiedlichen elektrischen Geräten Auswerte- und Steuerungsfunktionen, zum Beispiel zum Auswerten von Sensorsignalen und/oder zum Ansteuern von Aktoren oder dergleichen, zur Verfügung zu stellen.

Elektrische Geräte können hierbei entlang einer Querrichtung Y aneinander angereiht und an der Tragschiene 2 befestigt werden, um eine Anordnung von elektrischen Geräten an der Tragschiene 2 zu schaffen.

Bei dem elektrischen Gerät 1 ist eine Tragstruktur durch ein Kühlkörperkernelement 11 geschaffen, der einen Kern des elektrischen Geräts 1 ausbildet und an dem elektrische Funktionsbaugruppen in Form von Leiterplatten 13-16 mit daran angeordneten elektrischen oder elektronischen Funktionskomponenten 18 festgelegt sind. Das Kühlkörperkernelement 11 ist aus einem gut wärmeleitfähigen Material, insbesondere einem Metallmaterial, beispielsweise einem Kupfer-, Aluminium- oder Zinkmaterial, gefertigt und kann beispielsweise durch ein Stranggussprofil, zum Beispiel ein Aluminiumstranggussprofil, ausgebildet sein.

Das Kühlkörperkernelement 11 kann zum Beispiel durch Fräsen einer bestimmten Verwendung, insbesondere einer bestimmten Anordnung von Leiterplatten 13-16, angepasst sein, beispielsweise um Freimachungen in dem Kühlkörperkernelement 11 zu schaffen, an denen Komponenten der Leiterplatte 13-16 aufgenommen werden können.

Bei dem elektrischen Gerät 1 des Ausführungsbeispiels gemäß Fig. 1 bis 4 bildet das Kühlkörperkernelement 11 die tragende Struktur des elektrischen Geräts 1 aus. Das Kühlkörperkernelement 11 trägt die Leiterplatten 13-16 und ist über eine Befestigungseinrichtung 12 zudem an der zugeordneten Tragschiene 2 festgelegt, sodass das elektrische Gerät 1 über das Kühlkörperkernelement 11 und die daran angeordnete Befestigungseinrichtung 12 an der Tragschiene 2 gehalten ist.

Das Kühlkörperkernelement 11 weist parallel zueinander erstreckte Flächenwandungen 110 auf, die über eine rückseitige Tragwandung 113, eine vorderseitige Tragwandung 115 und zwischen den Flächenwandungen 110 erstreckte Kühlrippen 112 miteinander verbunden sind. Zwischen den parallel zueinander erstreckten Kühlrippen 111 sind Strömungsöffnungen zur Ausbildung eines Strömungsschachts 119 gebildet, die bei bestimmungsgemäßer Verbindung des elektrischen Geräts 1 mit einer zugeordneten Tragschiene 2 entlang einer vertikal gerichteten Höhenrichtung Z ausgerichtet sind und somit einen Konvektionsluftstrom durch das Kühlkörperkernelement 11 ermöglichen, um Wärme von dem Kühlkörperkernelement 11 abzuführen.

Das Kühlkörperkernelement 11 bildet mit den Flächenwandungen 110, 113, 115 eine Kubusform aus, die modular mit elektrischen Funktionsbaugruppen in Form von Leiterplatten 13-16 und daran angeordneten elektrischen und/oder elektronischen Funktionskomponenten 18 bestückt werden kann. Bei bestimmungsgemäßer Anordnung an der Tragschiene 2 ist der durch die Strömungsöffnungen zwischen den Kühlrippen 111 gebildete Strömungsschacht 119 vertikal ausgerichtet, sodass eine Konvektionsströmung durch den Strömungsschacht 119 hindurchströmen kann, um Wärme an dem Kühlkörperkernelement 11 aufzunehmen und abzuleiten.

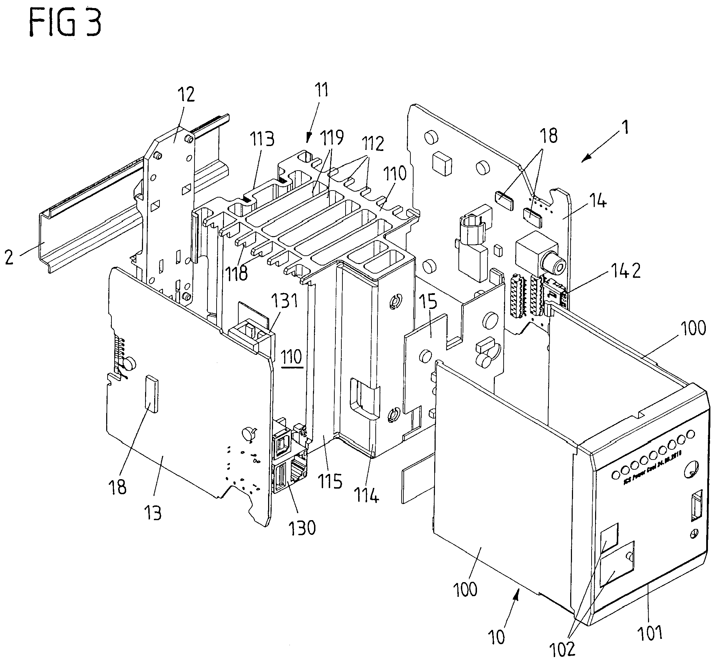

Wie aus Fig. 3 ersichtlich, ist außenseitig einer jeden Flächenwandung 110 eine zugeordnete Leiterplatte 13, 14 angeordnet. An jeder Flächenwandung 110 sind dazu vorstehende Rippenabschnitte 112 geformt, die Stützkanten 118 ausbilden und somit gemeinsam einen Sitz für eine jeweils zugeordnete Leiterplatte 13, 14 bereitstellen, über den die Leiterplatte 13, 14 gegenüber der zugeordneten Flächenwandung 110 mit Abstand abgestützt ist.

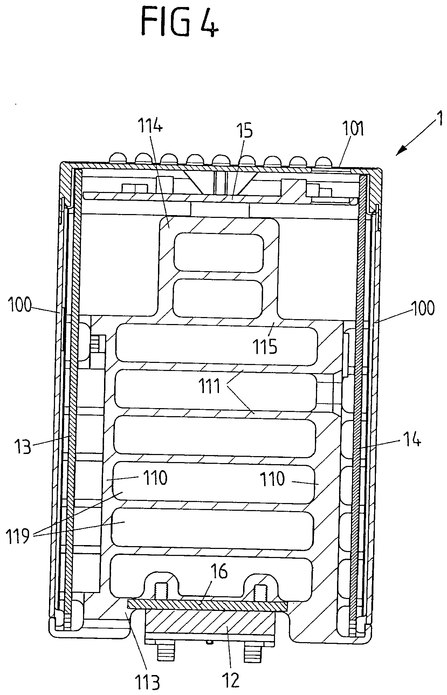

Zusätzlich ist eine Leiterplatte 15 im Bereich der vorderseitigen Tragwandung 115 angeordnet, wie dies aus Fig. 3 ersichtlich und zudem in Fig. 4 veranschaulicht ist.

Von der vorderseitigen Tragwandung 115 steht ein Körperabschnitt 114 entlang einer von der Tragschiene 2 weg gerichteten Längsrichtung X vor, über den eine Kühlung von Komponenten im Bereich der vorderseitigen Tragwandung 115 bereitgestellt werden kann. Die Befestigungseinrichtung 12 ist fest mit der der Tragschiene 2 zugewandten, rückseitigen Tragwandung 113 verbunden und dient zum Herstellen einer rastenden Verbindung mit der Tragschiene 2. Denkbar ist hierbei auch, die Befestigungseinrichtung 12, beispielsweise in Form von Rasthaken, integral mit der rückseitigen Tragwandung 113 zu formen.

Wie dies in Fig. 4 veranschaulicht ist, kann zusätzlich auch eine Leiterplatte 16 im Bereich der rückseitigen Tragwandung 113 angeordnet sein.

Die Flächenwandungen 110 erstrecken sich parallel zueinander in jeweils einer zugeordneten Ebene, die durch die Längsrichtung X und die Höhenrichtung Z aufgespannt ist. Die Kühlrippen 111 zwischen den Flächenwandungen 110, die rückseitige Tragwandung 113 und die vorderseitige Tragwandung 115 erstrecken sich demgegenüber jeweils entlang einer zugeordneten Querebene, die durch die Höhenrichtung Z und die quer zur Längsrichtung X erstreckte Querrichtung Y aufgespannt ist.

Die Leiterplatten 13-16 tragen elektrische und/oder elektronische Komponenten, an denen im Betrieb Wärme entstehen kann. Dadurch, dass die Leiterplatten 13-16 fest mit dem Kühlkörperkernelement 11 verbunden und thermisch mit dem Kühlkörperkernelement 11 gekoppelt sind, kann Wärme im Betrieb in das Kühlkörperkernelement 11 eingeleitet und über das Kühlkörperkernelement 11 abgeleitet werden, beispielsweise indem Wärme über eine Konvektionsströmung durch das Kühlkörperkernelement 11 hindurch abgeführt wird.

Bei dem Ausführungsbeispiel gemäß Fig. 1 bis 4 sind an den Leiterplatten 13, 14 beispielsweise Steckverbindermodule 130-132, 140-142 angeordnet, über die elektrische Leitungen an die Leiterplatten 13, 14 und somit das elektrische Gerät 1 angeschlossen werden können. Zusätzlich können weitere Bauelemente, zum Beispiel ein Blendenteil, an den Leiterplatten 13, 14 befestigt sein.

Bei dem Ausführungsbeispiel gemäß Fig. 1 bis 4 ist das elektrische Gerät 1 nach außen hin durch ein Gehäuseteil 10 eingefasst, das Außenelemente in Form von Seitenwänden 100 und eine Vorderwand 101 aufweist und somit im Wesentlichen U-förmig ausgebildet ist. Die Seitenwände 100 umgreifen die Leiterplatten 13, 14 an den Flächenwandungen 110 außenseitig, während die Vorderwand 101 der vorderseitigen Tragwandung 115 des Kühlkörperkernelements 11 zugewandt ist. Die Außenelemente in Form der Seitenwände 100 decken die Leiterplatten 13, 14 an den Flächenwandungen 110 somit derart nach außen hin ab, dass die Funktionsbaugruppen in Form der Leiterplatten 13, 14 mit den daran angeordneten elektrischen und/oder elektronischen Funktionskomponenten im Sandwich zwischen der jeweils zugeordneten Flächenwandung 110 und der Seitenwand 100 eingefasst sind.

Die Seitenwände 100 können beispielsweise aus einem elektrisch und thermisch isolierenden Material, zum Beispiel einem Kunststoffmaterial, gefertigt sein.

Alternativ können die Seitenwände 100 als zusätzliche Kühlkörperteile eine kühlende Funktion durch Wärmeaufnahme und Wärmeabfuhr bereitstellen und dazu beispielsweise aus einem gut wärmeleitfähigen Material, zum Beispiel einem Metallmaterial, beispielsweise einem Kupfer-, Aluminium- oder Zinkmaterial, gefertigt sein.

In montierter Stellung liegen zumindest einige der Steckverbindermodule 130-132, 140-142 der Leiterplatten 13, 14 in zugeordneten Öffnungen 102 an der Vorderwand 101 des Gehäuseteils 10 ein, sodass über die Vorderwand 101 und zusätzlich oberseitig und unterseitig (zum Beispiel über die Steckverbindermodule 131, 140) Leitungen an das elektrische Gerät 1 angeschlossen werden können.

Bei dem in Fig. 1 bis 4 dargestellten Ausführungsbeispiel hat das Gehäuseteil 10 an sich keine tragende Funktion. Die Tragstruktur des elektrischen Geräts 1 wird durch das Kühlkörperkernelement 11 bereitgestellt, über den die Befestigung an der Tragschiene 2 erfolgt und an dem zudem die Leiterplatten 13, 14, 15, 16 festgelegt sind. Das Gehäuseteil 10 stellt insofern lediglich eine Abdeckung nach außen bereit.

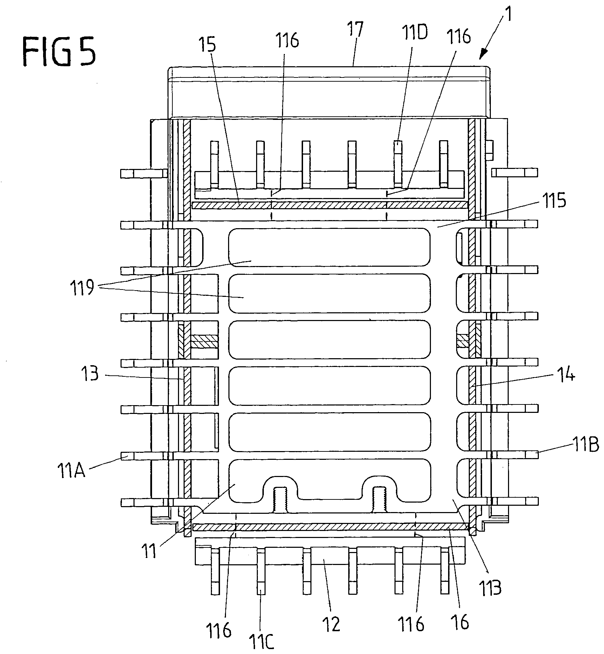

In einer schematisch in Fig. 5 dargestellten, anderen Ausgestaltung können an ein eine zentrale Tragstruktur darstellendes Kühlkörperkernelement 11 Außenelemente in Form von zusätzlichen Kühlkörperteilen 11A-11D angesetzt sein, die jeweils nach außen weisende Kühlrippen aufweisen, sodass Leiterplatten 13, 14, 15, 16 an seitlichen Flächenwandungen 110, an einer rückseitigen Tragwandung 113 und an einer vorderseitigen Tragwandung 115 des Kühlkörperkernelements 11 durch ein jeweils zugeordnetes Kühlkörperteil 11A-11D überdeckt sind. Die Leiterplatten 13, 14, 15, 16 sind somit jeweils im Sandwich zwischen dem Kühlkörperkernelement 11 und einem zugeordneten, mit dem Kühlkörperkernelement 11 verbundenen Kühlkörperteil 11A-11D aufgenommen, sodass die Leiterplatten 13, 14, 15, 16 beidseitig eingefasst sind.

Über Verbindungen 116 ist jedes Kühlkörperteil 11A-11D strukturell fest mit dem Kühlkörperkernelement 11 verbunden, wobei über die Verbindungen 116 zusätzlich zu einer mechanischen Verbindung auch eine thermische Kopplung hergestellt sein kann.

An einem der rückseitigen Tragwandung 113 zugeordneten, fest mit der rückseitigen Tragwandung 113 verbundenen Kühlkörperteil 11C ist bei dem Ausführungsbeispiel gemäß Fig. 5 die Befestigungseinrichtung 12 angeordnet, sodass über das rückseitige Kühlkörperteil 11C eine Verbindung mit der Tragschiene 2 hergestellt werden kann.

Die Befestigungseinrichtung 12 kann gegebenenfalls modular ausgetauscht und durch eine Befestigungseinrichtung zum Befestigen des elektrischen Geräts 1 an einer anderen Montagefläche oder Tragbasis ersetzt werden.

Die Kühlkörperteile 11A-11D können jeweils eine gerippte Struktur aufweisen. Die Kühlkörperteile 11A-11D sind aus einem gut wärmeleitfähigen Material, insbesondere einem Metallmaterial, beispielsweise einem Kupfer-, Aluminium- oder Zinkmaterial ausgebildet.

Bei dem Ausführungsbeispiel gemäß Fig. 5 ist ein Vorderteil 17 an das Kühlkörperkernelement 11 angesetzt und zum Beispiel über die seitlichen Kühlkörperteile 11A, 11B mit dem Kühlkörperkernelement 11 verbunden. Über das Vorderteil 17 können Eingabe- und/oder Ausgabefunktionen an dem elektrischen Gerät 1 bereitgestellt werden. Zusätzlich oder alternativ können an dem Vorderteil 17 auch elektrische Anschlüsse angeordnet sein.

Dadurch, dass sich sowohl bei dem Ausführungsbeispiel gemäß Fig. 1 bis 4 als auch beim Ausführungsbeispiel gemäß Fig. 5 Kühlrippen 111 zwischen den seitlichen Flächenwandungen 110 des Kühlkörperkernelements 11 erstrecken, kann eine vertikale Konvektionsströmung durch den durch Strömungsöffnungen gebildeten Strömungsschacht 119 innerhalb des Kühlkörperkernelements 11 strömen, um auf diese Weise Wärme von dem Kühlkörperkernelement 11 abzuführen. Zusätzlich oder alternativ kann auch eine aktive Kühlung an dem Kühlkörperkernelement 11 und/oder an den Kühlkörperteilen 11A-11D bereitgestellt werden, indem Kühlmittelleitungen an dem Kühlkörperkernelement 11 und/oder den Kühlkörperteilen 11A-11D geformt sind, durch die ein Kühlmittel geleitet werden kann, um Wärme an dem elektrischen Gerät 1 aufzunehmen und von dem elektrischen Gerät 1 abzuführen.

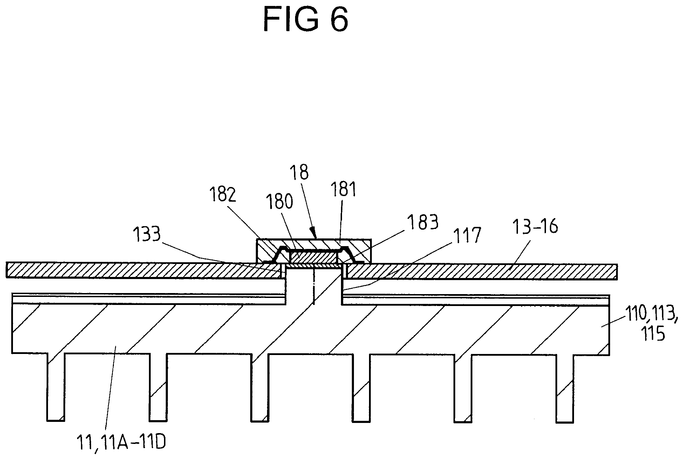

Wie dies in Fig. 6 dargestellt ist, können die Leiterplatten 13-16 elektrische und/oder elektronische Funktionskomponenten 18, beispielsweise elektrische Bauteile oder elektronische Komponenten wie Prozessoren, tragen, an denen im Betrieb Wärme entstehen kann, die über das Kühlkörperkernelement 11 und/oder die Kühlkörperteile 11A-11D abgeführt werden soll. Das Kühlkörperkernelement 11 und/oder die Kühlkörperteile 11A-11D können hierbei über Wärmeleitverbindungen 117 mit einer jeweils zugeordneten Komponente 18 thermisch verbunden sein, sodass Wärme an der Komponente 18 aufgenommen und abgeleitet werden kann.

Eine solche Wärmeleitverbindung 117 kann zum Beispiel zapfenförmig einstückig mit dem Kühlkörperkernelement 11 oder den Kühlkörperteilen 11A-11D geformt sein und kann sich beispielsweise durch eine Öffnung 133 in der Leiterplatte 13-16 hin zu der zum Beispiel an einer abgewandten Seite der Leiterplatte 13-16 angeordneten Komponente 18 erstrecken. Zur thermischen Kopplung kann hierbei zwischen der Wärmeleitverbindung 117 und einem elektrischen oder elektronischen Bauteil 180 der Funktionskomponente 18 eine Wärmeleitschicht 183 zum Beispiel in Form einer Wärmeleitpaste oder dergleichen angeordnet sein, sodass ein effektiver thermischer Übergang für eine wärmeleitende Verbindung zwischen dem Bauteil 180 und der Wärmeleitverbindung 117 geschaffen wird.

Das Bauteil 180 kann an der der Flächenwandung 110, 113, 115 abgewandten Seite durch eine Einhausung 181 gekapselt sein. Das Bauteil 180 kann hierbei an der der Flächenwandung 110, 113, 115 abgewandten Seite der Leiterplatte 13-16 über elektrische Verbindungen 182 mit der Leiterplatte 13-16 verbunden sein, sodass das Bauteil 180 an der der Flächenwandung 110, 113, 115 abgewandten Seite der Leiterplatte 13-16 elektrisch angebunden und beispielsweise mit Leiterbahnen der Leiterplatte 13-16 verbunden ist.

Anstelle einer integralen Formung mit dem Kühlkörperkernelement 11 oder den Kühlkörperteilen 11A-11D kann eine Wärmeleitverbindung 117 beispielsweise auch unter Verwendung einer Fügetechnik mit dem Kühlkörperkernelement 11 oder den Kühlkörperteilen 11A-11D verbunden sein, beispielsweise mittels Kleben.

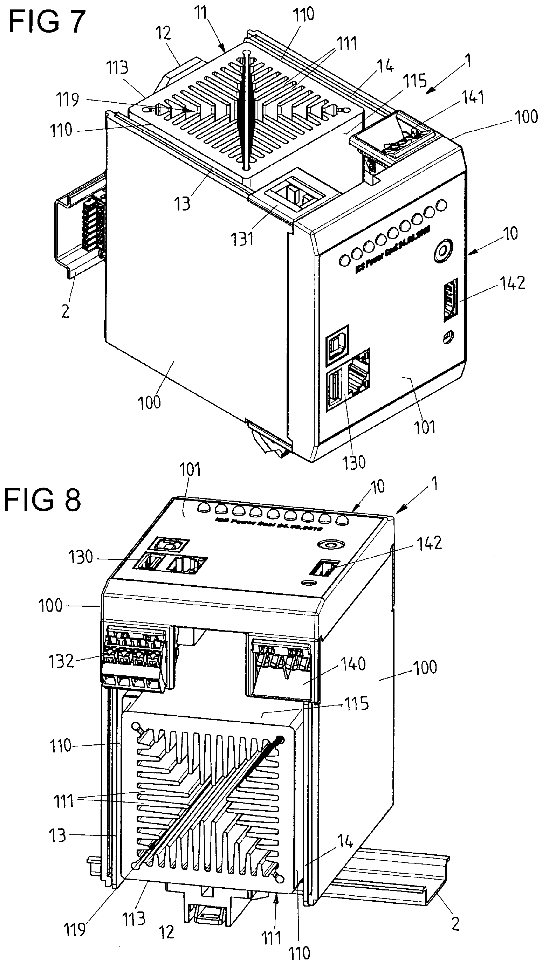

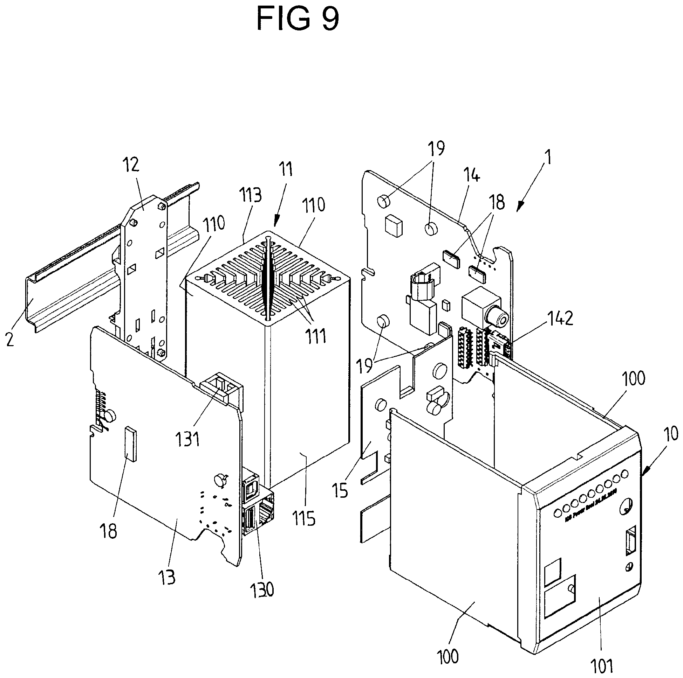

Bei einem in Fig. 7 bis 10 dargestellten Ausführungsbeispiel eines elektrischen Geräts 1 ist ein Kühlkörperkernelement 11, das eine Tragstruktur des elektrischen Geräts 1 ausbildet, als Kubus mit durch Flächenwandungen 110, 113, 115 ausgebildeten, gleichen Seiten ausgebildet. Das in Fig. 7 bis 10 dargestellte Ausführungsbeispiel ist gegenüber dem Ausführungsbeispiel gemäß Fig. 1 bis 4 hinsichtlich der Ausgestaltung des Kühlkörperkernelements 11 modifiziert, ansonsten aber im Wesentlichen funktionsgleich, sodass auch auf die obigen Ausführungen zum Ausführungsbeispiel gemäß Fig. 1 bis 4 verwiesen werden soll.

An jeder der Flächenwandungen 110, 113, 115 kann, wie dies aus Fig. 7 bis 10 ersichtlich ist, eine Leiterplatte 13-16 angeordnet werden, sodass an den Flächenwandungen 110, 113, 115 in modularer Weise elektrische Funktionsbaugruppen mit Leiterplatten 13-16 und daran angeordneten Funktionskomponenten 18 angeordnet werden können.

Bei dem Ausführungsbeispiel gemäß Fig. 7 bis 10 bildet das Kühlkörperkernelement 11 einen Kubus aus, der durch die Flächenwandungen 110, 113, 115 nach außen begrenzt ist und nach oben und nach unten (betrachtet entlang einer Vertikalrichtung, die bei bestimmungsgemäßer Anordnung des elektrischen Geräts 1 der Schwerkraftrichtung entspricht) offen ist. Innenseitig der Flächenwandungen 110, 113, 115 sind Kühlrippen 111 geformt, die sich in einen innerhalb des Kühlkörperkernelements 11 gebildeten Strömungsschacht 119 hinein erstrecken und jeweils senkrecht von einer zugeordneten Flächenwandung 110, 113, 115 vorstehen, wobei von den unterschiedlichen Flächenwandungen 110, 113, 115 erstreckte Kühlrippen 111 nicht miteinander verbunden sind und sich somit innerhalb des Kühlkörperkernelements 11 eine sternförmige Öffnung ergibt.

Analog wie bei dem Ausführungsbeispiel gemäß Fig. 1 bis 4 kann bei dem Ausführungsbeispiel gemäß Fig. 7 bis 10 an jede Flächenwandung 110, 113, 115 je eine Leiterplatte 13-16 einer elektrischen Funktionsbaugruppe angesetzt werden, wobei wahlweise auch nur an einzelnen der Flächenwandungen 110, 113, 115 eine Leiterplatte 13-16 angeordnet werden kann.

Die Verbindung der Leiterplatten 13-16 der elektrischen Funktionsbaugruppen mit dem Kühlkörperkernelement 11 kann über Befestigungselemente 19 in Form von an den Leiterplatten 13-16 angeordneten Distanzelementen erfolgen, sodass die Leiterplatten 13-16 auf Abstand zu den zugeordneten Flächenwandungen 110, 113, 115 gehalten sind. Über die Distanzelemente 19 kann eine mechanische Verbindung der Leiterplatten 13-16 mit den Flächenwandungen 110, 113, 115 hergestellt werden.

Zusätzlich können elektrische und/oder elektronische Funktionskomponenten 18 über Wärmeleitverbindungen 117, wie in Fig. 6 dargestellt, thermisch mit dem Kühlkörperkernelement 11 gekoppelt sein.

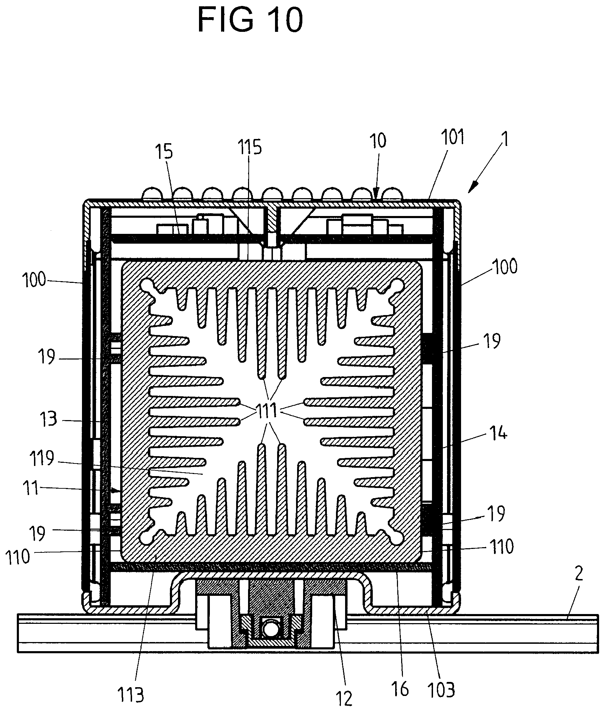

An einer rückwärtigen Flächenwandung 113 kann eine Befestigungseinrichtung 12 angeordnet werden, über die das elektrische Gerät 1 an einer Tragschiene 2 angeordnet werden kann. Die Befestigungseinrichtung 12 kann hierbei modular mit der Flächenwandung 113, gegebenenfalls unter Zwischenlage einer elektrischen Funktionsbaugruppe mit einer Leiterplatte 16 (siehe Fig. 10), verbunden werden, wobei auch andere Befestigungseinrichtungen zum Befestigen des elektrischen Geräts 1 an einer anderen Tragbasis unterschiedlich von einer Tragschiene 2 mit dem Kühlkörperkernelement 11 verbunden werden können.

An das Kühlkörperkernelement 11 kann ein Gehäuse 10 mit Gehäusewandungen 100, 101 angesetzt werden, um eine Einhausung für das elektrische Gerät 1 zu schaffen. Das Gehäuse 10 übernimmt hierbei selbst jedoch keine tragende Funktion, die stattdessen durch das Kühlkörperkernelement 11 übernommen wird.

Wie dies in Fig. 10 dargestellt ist, kann hierbei auch die rückwärtige, mit der Befestigungseinrichtung 12 verbundene Flächenwandungen 113 durch einen Wandungsabschnitt 103 des Gehäuses 10 überdeckt und somit nach außen eingehaust sein.

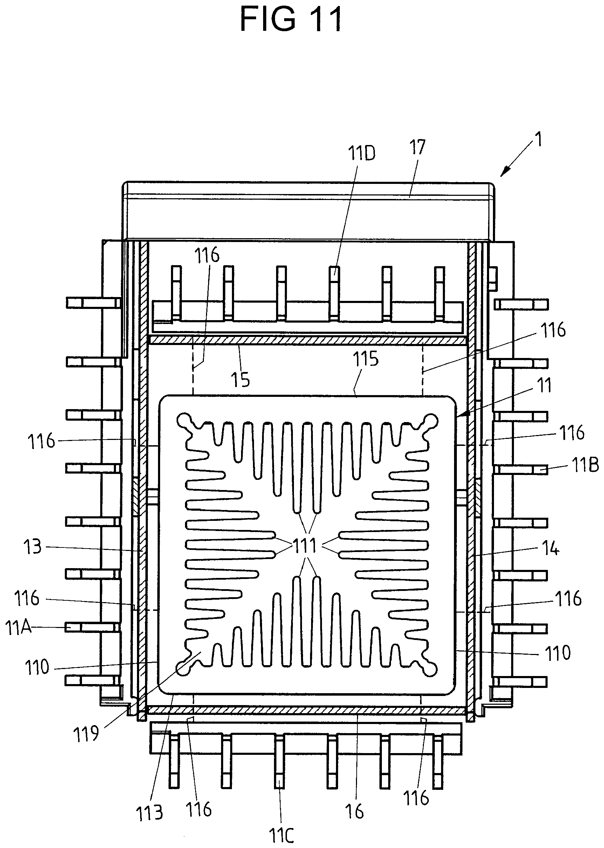

Wie dies in einem Ausführungsbeispiel in Fig. 11 dargestellt ist, können auch bei dem Kühlkörperkernelement 11 gemäß Fig. 7 bis 10 außenseitig weitere Kühlkörperteile 11A-11D angeordnet werden, über die elektrische Funktionsbaugruppen mit Leiterplatten 13-16 nach außen hin eingefasst und zumindest abschnittsweise abgedeckt werden können. Die Kühlkörperteile 11A-11D können, analog wie dies vorangehend anhand von Fig. 5 beschrieben worden ist, über Verbindungseinrichtungen 116 mechanisch und thermisch mit dem Kühlkörperkernelement 11 gekoppelt sein, sodass eine zusammenhängende Tragstruktur mit dem Kühlkörperkernelement 11 als zentralem Kern geschaffen wird.

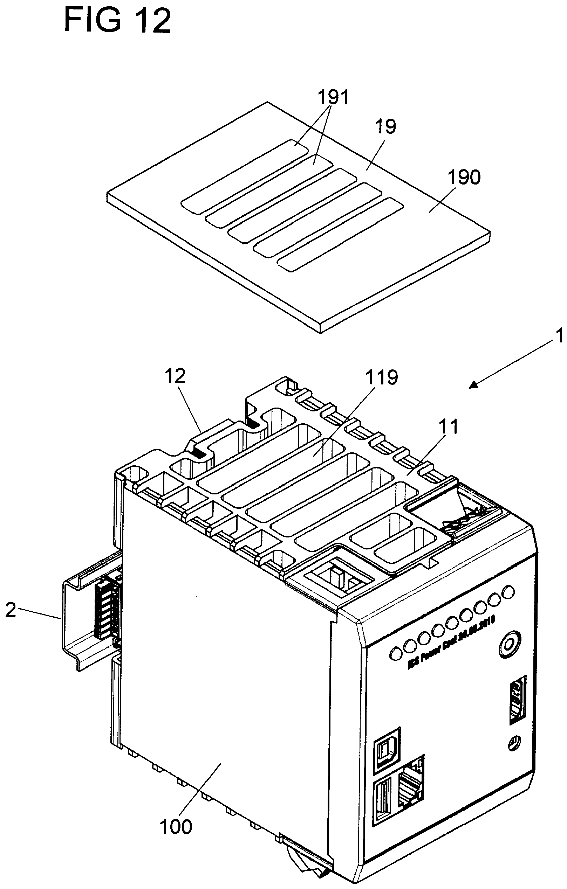

Bei sämtlichen der vorangehenden Ausführungsbeispiele kann, wie dies in Fig. 12 anhand des Ausführungsbeispiels gemäß Fig. 1 dargestellt ist, ein Stirnwandungselement 104 stirnseitig an das Kühlkörperkernelement 11 angesetzt sein, also an eine Stirnseite des Kühlkörperkernelements 11, die senkrecht zu den Flächenwandungen 110, 113, 115 des Kühlkörperkernelements 11 ausgerichtet ist. Das Stirnwandungselement 104 kann insbesondere Strömungsöffnungen 105 aufweisen und kann den in dem Kühlkörperkernelement 11 geformten Strömungsschacht 119 zumindest teilweise überdecken, wobei die Strömungsöffnungen 105 im Stirnwandungselement 104 mit dem Strömungsschacht 119 bzw. einzelnen Kanälen des Strömungsschachts 119 zumindest teilweise fluchten, sodass ein Fluidstrom durch den Strömungsschaft 119 hindurchströmen kann.

Das Stirnwandungselement 104 kann beispielsweise aus einem elektrisch und thermisch isolierenden Material, zum Beispiel einem Kunststoffmaterial gefertigt sein. Das Stirnwandungselement 104 stellt somit einen Berührschutz zur Verfügung und deckt zudem das Kühlkörperkernelement 11 stirnseitig nach außen hin ab, sodass eine optische Blende bereitgestellt wird und das Kühlkörperkernelement 11 von außen nicht unmittelbar sichtbar ist.

Ein elektrisches Gerät 1 der beschriebenen Art kann insbesondere im Rahmen eines Baukastensystems zur Verfügung gestellt werden und flexibel konfigurierbar sein. Im Rahmen eines solchen Baukastensystems können unterschiedliche Kühlkörperkernelemente 11 und zudem mit den unterschiedlichen Kühlkörperkernelementen 11 jeweils verbindbare Außenelemente in Form von weiteren Kühlkörperteile 11A-11D oder Gehäusewandungen 100 zur Verfügung gestellt werden, sodass ein Nutzer aus unterschiedlichen Kühlkörperkernelementen 11 und zudem variabel verfügbaren Außenelementen auswählen kann, um das elektrische Gerät 1 zu konfigurieren und herzustellen.

Unterschiedliche Kühlkörperkernelemente 11 können insbesondere unterschiedliche Breiten, entlang der Längserstreckungsrichtung der Tragschiene 2, aufweisen, sodass durch Auswahl eines geeigneten Kühlkörperkernelements 11 beispielsweise elektrische Geräte 1 unterschiedlicher Leistungsklassen zur Verfügung gestellt werden können. Mit den unterschiedlichen Kühlkörperkernelementen 11 sind hierbei sämtliche der Außenelemente des Baukastensystems verbindbar, sodass ein Anwender variabel aus unterschiedlichen Außenelementen zum Beispiel abhängig von einer Kühlfunktion auswählen kann, um zum Beispiel über zusätzliche Kühlkörperteile eine zusätzliche Kühlung bereitzustellen oder durch Auswahl einer Gehäusewandung lediglich eine äußere Abdeckung zu schaffen.

Der der Erfindung zugrunde liegende Gedanke ist nicht auf die vorangehend beschriebenen Ausführungsbeispiele beschränkt, sondern lässt sich auch in anderer Weise verwirklichen.

Dadurch, dass bei dem elektrischen Gerät das Kühlkörperkernelement eine Tragstruktur ausbildet, über die Leiterplatten getragen und zudem eine Verbindung mit einer Tragschiene oder einer anderen Tragbasis hergestellt werden kann, kann ein elektrisches Gerät mit einfachem Aufbau erhalten werden, bei dem zudem die Bauteileanzahl reduziert ist. Auf diese Weise kann sich eine effiziente Montage und kostengünstige Fertigung für das elektrische Gerät ergeben.

Ein solches elektrisches Gerät kann eine einer Tragschiene zu befestigenden sein oder auch an einer anderen tragbares, zum Beispiel einer Montagefläche oder einer von einer Tragschiene unterschiedlichen Befestigungseinrichtung zum Beispiel innerhalb eines Schaltschranks.

Dadurch, dass die Tragstruktur durch ein Kühlkörperkernelement gebildet ist, ergibt sich zudem eine effiziente Kühlung, sodass eine günstige Wärmeabfuhr ermöglicht werden kann. Es ergibt sich ein sowohl mechanisch stabiles als auch thermisch robustes elektrisches Gerät, das in vielfältiger Weise, insbesondere in unterschiedlichen Leistungsklassen und mit unterschiedlichen Gehäuseformfaktoren, eingesetzt werden kann.

### Bezugszeichenliste

- 1: Elektrisches Gerät
- 10: Gehäuseteil
- 100: Außenelement (Gehäusewandung)
- 101: Vorderwand
- 102: Öffnung
- 103: Wandungsabschnitt
- 104: Stirnwandungselement
- 105: Strömungsöffnungen
- 11: Kühlkörper (Tragstruktur)
- 11A-11D: Außenelement (Kühlkörperteil)
- 110: Flächenwandung
- 111: Kühlrippen
- 112: Rippenabschnitte
- 113: Flächenwandung (rückseitige Wandung)
- 114: Körperabschnitt
- 115: Flächenwandung (vorderseitige Wandung)
- 116: Verbindungseinrichtung
- 117: Wärmeleitverbindung
- 118: Stützkante
- 119: Strömungsschacht
- 12: Befestigungseinrichtung
- 13-16: Trägerelement (Leiterplatte)
- 130-132: Steckverbindermodul
- 133: Öffnung
- 140-142: Steckverbindermodul
- 17: Vorderteil
- 18: Funktionskomponente
- 180: Bauteil
- 181: Einhausung
- 182: Elektrische Verbindung
- 183: Wärmeleitschicht (Wärmeleitpaste)
- 19: Befestigungselemente
- 2: Tragschiene
- X: Längsrichtung
- Y: Querrichtung
- Z: Höhenrichtung

## Patentansprüche

1. Baugruppe eines elektrischen Geräts (1), mit zumindest einer elektrischen Funktionsbaugruppe, die ein Trägerelement (13-16) und an dem Trägerelement (13-16) angeordnete elektrische oder elektronische Funktionskomponenten (18) aufweist, und einer Befestigungseinrichtung (12) zum Befestigen des elektrischen Geräts (1) an einer übergeordneten Baugruppe, **gekennzeichnet durch** ein zumindest eine Flächenwandung (110, 113, 115) aufweisendes Kühlkörperkernelement (11) und ein mit dem Kühlkörperkernelement (11) verbindbares Außenelement (100, 11A-11D), wobei das Kühlkörperkernelement (11) eine Tragstruktur des elektrischen Geräts (1) ausbildet, an der die Befestigungseinrichtung (12) angeordnet ist, und das Außenelement (100, 11A-11D) derart mit dem Kühlkörperkernelement (11) verbindbar ist, dass die Funktionsbaugruppe zwischen der zumindest einen Flächenwandung (110, 113, 115) des Kühlkörperkernelements (11) und dem Außenelement (100, 11A-11D) aufgenommen ist.

2. Baugruppe nach Anspruch 1, **dadurch gekennzeichnet, dass** das Kühlkörperkernelement (11) zwei parallel zueinander erstreckte Flächenwandungen (110, 113, 115) aufweist, wobei elektrische Funktionsbaugruppen an einander abgewandten Seiten der zwei Flächenwandungen (110) befestigbar sind.

3. Baugruppe nach Anspruch 2, **dadurch gekennzeichnet, dass** Kühlrippen (111) zwischen den zwei parallel zueinander erstreckten Flächenwandungen (110, 113, 115) geformt sind.

4. Baugruppe nach Anspruch 2 oder 3, **dadurch gekennzeichnet, dass** je ein Außenelement (100, 11A-11D) mit den zwei parallel zueinander erstreckten Flächenwandungen (110, 113, 115) verbindbar ist.

5. Baugruppe nach einem der vorangehenden Ansprüche, **dadurch gekennzeichnet, dass** das Kühlkörperkernelement (11) vier Flächenwandungen (110, 113, 115) aufweist, die zur Ausbildung einer kubusförmigen Tragstruktur rechtwinklig zueinander angeordnet sind, wobei an jeder der Flächenwandungen.

6. Baugruppe nach einem der vorangehenden Ansprüche, **dadurch gekennzeichnet, dass** die zumindest eine elektrische Funktionsbaugruppe an einer ersten Seite einer zugeordneten Flächenwandung (110, 113, 115) befestigbar und Kühlrippen an einer der ersten Seite abgewandten, zweiten Seite der Flächenwandung (110, 113, 115) geformt sind.

7. Baugruppe nach einem der vorangehenden Ansprüche, **dadurch gekennzeichnet, dass** das Kühlkörperkernelement (11) zumindest einen durch ein Fluid durchströmbaren Strömungsschacht (119) aufweist.

8. Baugruppe nach Anspruch 7, **dadurch gekennzeichnet, dass** der Strömungsschacht (119) bei bestimmungsgemäßer Verwendung der Baugruppe vertikal zum Leiten einer Konvektionsströmung gerichtet ist.

9. Baugruppe nach Anspruch 7 oder 8, **gekennzeichnet durch** einen aktiven Lüfter zum Befördern eines Fluidstroms durch den Strömungsschacht (119).

10. Baugruppe nach Anspruch 7 bis 9, **dadurch gekennzeichnet, dass** Kühlrippen (111) in den Strömungsschacht (119) hineinragen.

11. Baugruppe nach einem der Ansprüche 7 bis 10, **dadurch gekennzeichnet, dass** die zumindest eine elektrische Funktionsbaugruppe an einer dem Strömungsschacht (119) abgewandten Seite der zumindest einen Flächenwandung (110, 113, 115) befestigbar ist.

12. Baugruppe nach einem der Ansprüche 7 bis 11, **gekennzeichnet durch** ein aus einem elektrisch isolierenden Material gefertigtes Stirnwandungselement (104), das zumindest eine Strömungsöffnung (105) für einen Fluidstrom aufweist und an dem Kühlkörperkernelement (11) derart befestigbar ist, dass das Stirnwandungselement (104) den Strömungsschacht (119) zumindest teilweise überdeckt.

13. Baugruppe nach einem der Ansprüche 1 bis 12, **dadurch gekennzeichnet, dass** das Außenelement (100, 11A-11D) durch ein Kühlkörperteil gebildet ist, das mit dem Kühlkörperkernelement (11) verbindbar ist, um die zumindest eine elektrische Funktionsbaugruppe zwischen der zumindest einen Flächenwandung (110, 113, 115) und dem Kühlkörperteil aufzunehmen.

14. Baugruppe nach Anspruch 13, **dadurch gekennzeichnet, dass** das Kühlkörperteil thermisch mit dem Kühlkörperkernelement (11) gekoppelt ist.

15. Baugruppe nach einem der Ansprüche 1 bis 12, **dadurch gekennzeichnet, dass** das Außenelement (100, 11A-11D) durch eine Gehäusewandung eines das Kühlkörperkernelement (11) einhausenden Gehäuses (10) gebildet ist, die mit dem Kühlkörperkernelement (11) verbindbar ist, um die zumindest eine elektrische Funktionsbaugruppe zwischen der zumindest einen Flächenwandung (110, 113, 115) und der Gehäusewandung aufzunehmen.

16. Baugruppe nach einem der vorangehenden Ansprüche, **dadurch gekennzeichnet, dass** das Außenelement (100, 11A-11D) schwimmend mit dem Kühlkörperkernelement (11) verbunden ist derart, dass das Außenelement (100, 11A-11D) zumindest entlang einer Raumrichtung zu dem Kühlkörperkernelement (11) bewegbar ist.

17. Baugruppe nach einem der vorangehenden Ansprüche, **dadurch gekennzeichnet, dass** die übergeordnete Baugruppe eine Tragschiene (2) zum Aufnehmen einer Mehrzahl von elektrischen Geräten ist.

18. Baugruppe nach einem der vorangehenden Ansprüche, **dadurch gekennzeichnet, dass** das Trägerelement (13-16) der zumindest einen elektrischen Funktionsbaugruppe durch eine Leiterplatte gebildet ist.

19. Baugruppe nach einem der vorangehenden Ansprüche, **dadurch gekennzeichnet, dass** die Funktionsbaugruppe ein SOM-Board aufweist, das mit dem Trägerelement (13-16) der zumindest einen elektrischen Funktionsbaugruppe verbindbar ist.

20. Baugruppe nach einem der vorangehenden Ansprüche, **dadurch gekennzeichnet, dass** an der zumindest einen Flächenwandung (110, 113, 115) eine Mehrzahl von Auflageabschnitten (112) geformt ist, an denen das Trägerelement (13-16) der zumindest einen elektrischen Funktionsbaugruppe befestigbar ist.

21. Baugruppe nach Anspruch 20, **dadurch gekennzeichnet, dass** die Auflageabschnitte (112) von der zumindest einen Flächenwandung (110, 113, 115) vorstehen derart, dass das Trägerelement (13-16) in befestigter Stellung mit einem Abstand zu der zumindest einen Flächenwandung (110, 113, 115) angeordnet ist.

22. Baugruppe nach einem der vorangehenden Ansprüche, **dadurch gekennzeichnet, dass** das Kühlkörperkernelement (11) einstückig aus einem wärmeleitfähigen Material geformt ist.

23. Baukastensystem einer Baugruppe nach einem der vorangehenden Ansprüche, wobei das Baukastensystem eine Gruppe von unterschiedlichen Kühlkörperkernelementen (11) und eine Gruppe von unterschiedlichen, jeweils mit den Kühlkernelementen (11) verbindbaren Außenelementen (100, 11A-11D) aufweist, wobei zur Herstellung des elektrischen Geräts (1) eines der Kühlkörperkernelemente (11) und zumindest eines der Außenelemente (100, 11A-11D) auswählbar ist.

24. Baukastensystem nach Anspruch 23, **gekennzeichnet durch** eine Mehrzahl von unterschiedlichen Befestigungseinrichtungen (12) zur Befestigung an einer übergeordneten Baugruppe.

25. Elektrisches Gerät (1), mit einer Baugruppe nach einem der Ansprüche 1 bis 22, wobei die zumindest eine elektrische Funktionsbaugruppe an der zumindest einen Flächenwandung (110, 113, 115) des Kühlkörperkernelements (11) befestigt ist.

26. Elektrisches Gerät (1) nach Anspruch 25, **dadurch gekennzeichnet, dass** elektrische oder elektronische Funktionskomponenten (18) der zumindest einen elektrischen Funktionsbaugruppe an einer der zumindest einen Flächenwandung (110, 113, 115) zugewandten Seite des Trägerelements (13-16) und/oder an einer von der zumindest einen Flächenwandung (110, 113, 115) abgewandten Seite des Trägerelements (13-16) angeordnet sind.

27. Elektrisches Gerät (1) nach Anspruch 25 oder 26, **gekennzeichnet durch** eine Wärmeleitverbindung (117), über die die zumindest eine Flächenwandung (110) thermisch mit zumindest einer elektrischen oder elektronischen Funktionskomponente (18) der zumindest einen elektrischen Funktionsbaugruppe verbunden ist.

28. Elektrisches Gerät (1) nach Anspruch 27, **dadurch gekennzeichnet, dass** das Trägerelement (13-16) der zumindest einen elektrischen Funktionsbaugruppe eine Öffnung (133) aufweist, durch die hindurch die Wärmeleitverbindung (117) erstreckt ist, sodass die Wärmeleitverbindung (117) die zumindest eine Flächenwandung (110) thermisch mit einer elektrischen oder elektronischen Funktionskomponente (18) der zumindest einen elektrischen Funktionsbaugruppe an einer von der zumindest einen Flächenwandung (110, 113, 115) abgewandten Seite des Trägerelements (13-16) verbindet.
